# EUROPEAN PATENT APPLICATION

(11) **EP 1 274 113 A1**
(43) Date of publication of application: **08.01.2003**
(21) Application number: 01116128.8
(22) Date of filing: 03.07.2001
(51) Int. Cl.: H01J 37/02, H01J 37/32, C23C 14/56

(54) **Arrangement and method for detecting sidewall flaking in a plasma chamber**

(71) Applicant: Infineon Technologies SC300 GmbH & Co. KG, 01099 Dresden (DE)
(72) Inventor: Baier, Ulrich, 01307 Dresden (DE)
(74) Representative: Epping Hermann & Fischer

(57) **Abstract**

A light source (7), preferably a laser, and a detector (2), e.g. a CCD or diode array, are provided for measuring the intensity (8) of light (6) scattered by polymer film material (9) deposited on the wall surface (10) of a plasma chamber (1) in an plasma etch reactor. When disadvantageous flaking starts, the intensity (8) of scattered light (6) increases e.g. with respect to the intensity (8') of directly reflected light (5), which can be monitored and answered by issuing a warning signal. A suitable cleaning step is initiated, thus leading to a reduction of contaminating particles or metal impurities in semiconductor device manufacturing. Problems can be recognised during the etch process and time is additionally saved by the present in-situ measurement.

## Description

The present invention relates to an arrangement for detecting sidewall flaking in a plasma etch reactor, which is used for etching a semiconductor device.

With the continuous shrinkage of structure sizes of integrated circuits in semiconductor device manufacturing, the requirements for prohibiting particle contamination become increasingly stronger. The limits for accepting particulate contamination therefore have to be shrinked as well.

One main contributor to particle contamination in semiconductor device manufacturing is the etching process.

In accordance with current semiconductor device manufacturing technology, plasma etching provides a flexible and high-quality method to etch patterns defined by a photo resist mask into the substrate. A plasma is generated by means of a radio frequency (RF) power applied to one or more electrodes mounted in a plasma chamber. Processing gases suited for etching the substrate surface chemistry are excited upon application of the RF power and start to bombard the surface with energies depending on the kind and number of electrodes, the gas pressure and amount of activation energy deposited by the radio frequency.

Generally, high ion power can be needed to impose etch structuring to, e. g., silicon oxides, which can be provided by high plasma densities at low gas pressures. Unfortunately, the plasma chamber wall surfaces and the surfaces of other consumable parts inside the plasma chamber suffer as well from the ion bombardment.

E.g., Al₂O₃ used as the wall surface material has a disadvantage that aluminum oxide being released from the wall surface due to being hit by high energy ions might mix with the plasma, and then can be deposited embedded inside organic polymers on e.g. the semiconductor wafer or back on the wall surface. While the depositing effect on the wafer leads to metallic impurity contamination, the layer building up on the wall surface can disadvantageously not easily be removed in an in-situ plasma chamber clean step. A powdery, flaking film develops containing C, Al, O or F, which in case of flaking inevitably results in increased particle counts.

In case of using quartz as the surface material, a disadvantage becomes apparent due to its low thermal conductivity rendering an accurate temperature control hard to maintain. If large temperature changes occur, etch polymers deposited on the surface start flaking, thereby causing the generation of contaminating particles.

It is therefore a primary objective of the present invention to provide a means for reducing particle and metallic impurity contamination that originates from sidewall flaking in plasma chambers of plasma etch reactors.

The objective is solved by an arrangement for detecting sidewall flaking in a plasma chamber of a plasma etch reactor, which is used for etching a semiconductor device, comprising a light source, which is arranged to emit a beam of light towards an area on a inner wall surface, which is positioned inside the plasma chamber of said plasma etch reactor, at least one detector for detecting and measuring the intensity of light emitted by said light source and being scattered by said area of said inner wall surface, a control unit being connected to said light source and to said detector, and a method for detecting said sidewall flaking.

According to the present invention, a feature of flaking film material is utilized, that light directed upon corresponding contaminated surfaces is scattered with an intensity, which particularly changes, i.e. increases or decreases, if flaking or splintering off of polymer particles becomes prominent. That is, a small amount of intensity is taken from the beam of light spotting the corresponding surface and is converted into or from scattered light instead of contributing to the intensity of the reflected beam. The detector is used to measure this intensity. Advantageously, the intensity can be continuously monitored even during etch process, and be controlled by comparing the intensity with a threshold value that has been set by experience in advance, and which corresponds to a situation where flaking is about to start.

It has been found that flaking sets in abruptly and thus, the corresponding intensity changes in a step-like manner.

In a preferred aspect, the light source will be embodied as a laser concentrating its beam of light onto a defined spot on the inner wall surface of the plasma chamber. In this case, the intensity of reflected and scattered light can easily be separated. A main advantage of the present invention is, therefore, that the generation on metal impurity contamination or contaminating particles can be detected prior to the time of occurrence, thus reducing the amount of rework due to the reduced amount of contaminating particles. Moreover, tedious particle tests using e.g. a scanning electron microscope (SEM) or scatterometry that typically is performed every two days can be skipped, thereby saving machine and operator time.

Furthermore, strong efforts spent in opening the plasma chamber, removing consumable parts, cleaning those parts with a solvent liquid and restoring them into the chamber, e.g. every 100 RF hours can be minimised by determining the exact time of necessity of executing these steps according to the present invention. Additionally, problems with the etch process can be detected prematurely.

In a further aspect, the light source, or laser, is considered to be mounted freely movable for providing multiple spots to be covered by the beam of light. This feature also allows to detect systematic differences and to determine most problematic locations inside the chamber as well as maintaining statistical fluctuations of deposition locations.

In a further aspect, the light source is considered to be mounted outside the plasma chamber, while a window made of sufficiently etch-resistant material being transparent for the corresponding light provides the beam to enter the plasma chamber into the direction of the desired spots.

In a further aspect, the detector is considered to be one of a group comprising a CCD-device or a photo diode array. These detectors covering a sufficient spatial extent for the scattered light may be hidden behind corresponding windows which consist of etch resistant material, i.e. resistant against the processing gases. Preferably, the arrangement is constructed such that the detectors are not in contact with the plasma generated by the RF-source, but an implementation of the detector inside the plasma chamber is also possible in an alternative advantageous configuration.

According to the present invention, it is generally considered that the light source emits a beam through a first window into the plasma chamber onto the spot on the wall surface, from which scattered light radiates towards a detector. Here, the light is scattered by the rough surface of the flaking material, e.g. polymer film, being orientated towards the inner plasma chamber space.

Another aspect considers the rough flaking film, e.g. polymer film, backside orientated towards and being in contact with the wall surface, which in this case is embodied as a window through which the light beam is radiated from a light source and scattered back by said rough polymer film backside again through said window. While in the former case, the detector window - or the detector inside the chamber respectively - should be located in a considerably contamination-free area of the plasma chamber, the location of the combined detector and light source window preferably is located in an area suffering strongly from polymer or other material deposition.

Such an ideal location, in which the present invention most advantageously works, corresponds to a placement of the detector window, or the detector itself, on the sidewall of the exhaust tubes leading to evacuation pumps of the plasma reactor. While this position remains significantly contamination-free, it has direct optical access to regions having prominent contamination. In a further aspect, an additional detector is used to measure the intensity of the reflected light beam in order to provide a means for correlating intensity variations of the scattered light with intensity variations of the reflected light beam. This can be important, e.g., if the detector window region - or the detector array inside the chamber - is also contaminated temporarily or permanently due to deposited films. This rules out erroneous intensity variations not originating from the measured spot itself.

In further aspects configurations for providing a multidirectional beam towards the wall surface is considered. In one aspect the beam direction is changed by means of a rotatable mirror. A main advantage is, that for example said laser needs not be moved in order to scan the wall surface. In another aspect an optical means is provided, e.g. a beam splitter, which expands fanlike the beam concurrently onto the dedicated wall positions, rendering a mirror or laser movement unnecessary, thereby accelerating the measurement of scattering light intensity as a function of wall position.

Further advantages and aspects are evident from the dependent claims.

The invention will be better understood by reference to embodiments taken in conjunction with the accompanying figures, wherein

Figure 1 schematically shows reflection and scattering of an incident beam from a rough polymer film deposited on the wall surface of a plasma chamber (a) with a detector measuring only the scattered light, and the development of an intensity curve measured by the detector (b),

Figure 2 shows an embodiment of a plasma chamber being traversed by a set of incident laser beams spotting areas on the wall surface and being reflected onto a set of detectors being mounted above an exhaust tube leading to an evacuation pump,

Figure 3 shows another schematic representation of an embodiment where the flaking polymer film is irradiated from the backside through a window, the scattered light being detected by a photo detector being mounted behind the same window.

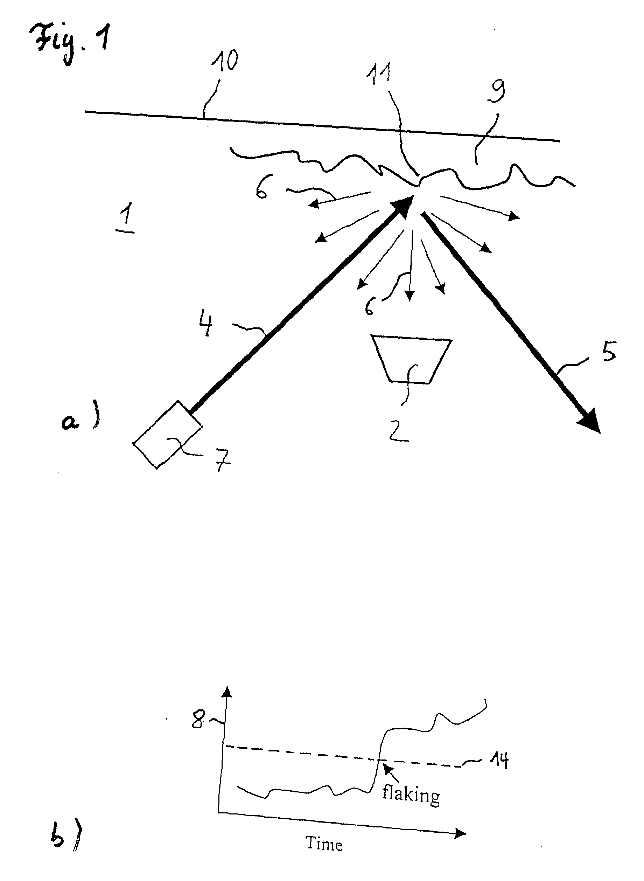

A schematic representation of the present invention is shown in figure 1. According to this embodiment, a laser 7 emits a beam of light 4 onto an inner wall surface 10 of a plasma chamber 1, which is covered by a polymer film 9 having a rough surface structure. The beam of light 4 intersects the wall surface 10 and the polymer film 9 at an area 11. The polymer film 9, which typically is growing with time, contains etch product chemistry as well as physically removed material from the substrate or plasma chamber surface material, e. g. SiO₂, aluminum, organic resist material, F, C and combinations thereof, and the like.

The main intensity 8' is reflected from the plain surface contribution under the condition that the inclination angle equals the reflection angle into a reflected beam of light 5. A detector 2 is positioned such that it cannot measure the intensity 8' of the reflected beam of light 5 although its photo sensitive elements are directed towards the spotted area 11 located on the wall surface 10 having a polymer film 9.

Depending on the roughness of the surface micro-structure of polymer film 9, thereby providing a variety of surface elements with different inclination angles relative to the incident beam of light 4, some amount of the incident beam intensity is converted into the resulting intensity 8 of scattered light that emits from the spotted area 11 either isotropically or unisotropically into different directions.

With accumulated etching, the polymer film 9 consecutively builds up and - by growing thicker - slowly increases the possibility of scattering. At some instance, depending on thickness and material involved, the hitherto undulatory polymer film surface obtains a precipitous profile which indicates that flaking starts. Polymer film 9 surface elements then occasionally lose support and may contribute to particle contamination. This sudden development is reflected in a steep increase of scattering light intensity 8 as being detected by detector 2. A corresponding intensity measurement performed by said detector 2 monitored against time is shown in figure 1b.

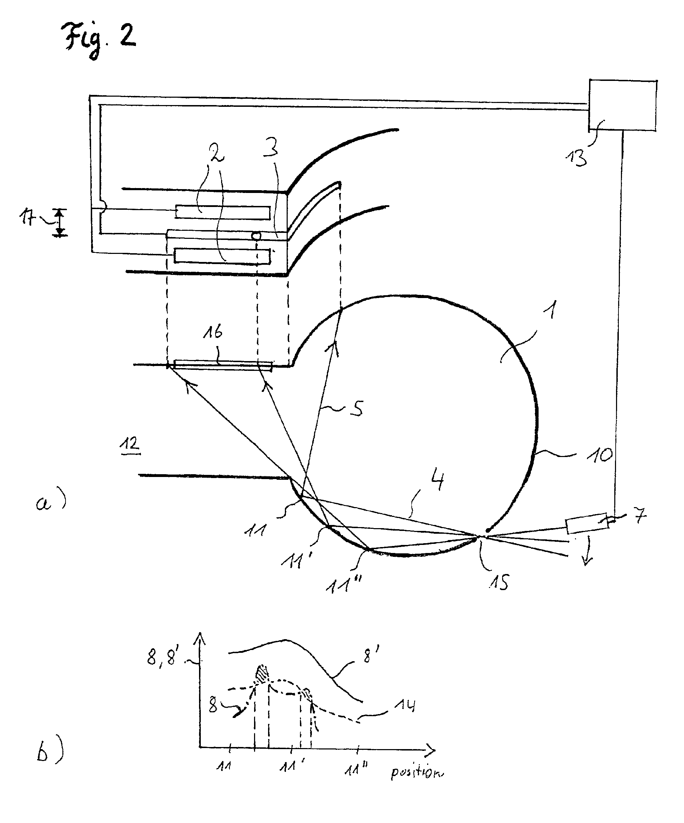

An embodiment according to the present invention is shown in figure 2. The etch products of processing gases generated in plasma chamber 1 are led out of the chamber through exhaust tubes 12 leading to an evacuation pump, as can be seen in figure 2a. By moving the position of a laser 7 emitting light through a light source window inside the plasma chamber wall surface 10 into the plasma chamber 1 having a variety of inclination angles at the spotted areas 11, 11', 11'' on the wall surface 10. The position of laser 7 can be varied continuously such as to scan a continuous line of areas on the wall surface 10. From there, the incident beam 4 is reflected as a reflected beam 5 through a detector window 15 onto a photo diode array 3 arranged as a line covering possible intersections of the reflected beams 5 with the upper part of the wall surface 10. This position has advantageously been chosen since polymer film deposition is found to be particularly weak at this location, thus providing a clear beam signal to the detectors 2, 3.

When flaking occurs, the intensity 8 of scattered light increases, which is detected by two photo diode arrays 2 arranged in a distance 17 from the photo diode array 3 representing the position of the reflected beam 5. The distance 17 represents the deviation of a scattering angle to the reflection angle. The lines of photo diode arrays 2, 3 are shown in the upper top view in figure 2a.

By scanning different areas 11, 11', 11'', etc. with laser 7, different parts of the photo diode arrays 2, 3 are spotted with scattered or reflected light. Thus, a polymer or other material film profile with respect to its surface structure can be monitored at each time step. An example is shown in figure 2b. The reflected beam intensity 8' received by a control unit 13 from photo diode array 3 is used to obtain a threshold value 14, which indicates the start of flaking. The threshold value 14 has been determined at some initial step by comparing intensity signals 8 of scattered light with, e.g., SEM-images or by similar investigations.

The use of the reflected beam intensity 8' as a normalizing input to the threshold value 14 provides some degree of independence from local conditions such as inclination angle dependent absorption or detector window absorption.

The control unit 13 also receives scattered light intensity 8 data as a function of position and compares these data with the position dependent threshold 14 as inferred from the reflected beam intensity 8'.

Thus, on the one hand side, the occurrence of flaking is detected, and on the other hand side, even the position can be derived where flaking first sets in, which is indicated in the plot of figure 2b as the two marked areas. The position of the areas 11, 11', 11'' can be known since the position of laser 7 is also monitored by the control unit 13, which can be associated with the corresponding photo diode array element.

Once a threshold value 14 violation is detected, a warning signal is issued urging an operator to terminate the current etch process for initiating a suitable wet clean step or clean and/or substitute single consumable parts of the plasma chamber.

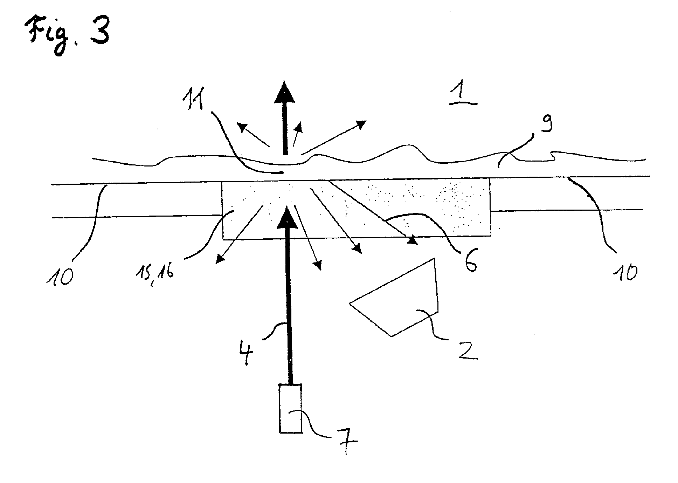

A further embodiment of the present invention is shown in figure 3. There, the laser 7 and the detector 2 are arranged behind a window 15, 16 structured inside the plasma chamber wall and the area 11 on the wall surface 10, which is covered by the polymer film 9 inside the plasma chamber 1 is thus lightened from behind. When flaking starts, light 6 is being scattered back through the window 15, 16 in a variety of directions among them is arranged the detector 2. The advantage is that only one window is needed and that no complicated conditions along the path of light have to be taken into account for providing a suitable threshold value. Rather, the window 15, 16 surface itself is the wall surface 10 being covered with the polymer film 9. As a further refinement, the laser 7 and the detector 2 can be mounted on the same stage, which is driven along the window 15, 16 extent, thereby maintaining constant conditions satisfying the requirement that the detector 2 only measures scattered light 6 instead of a reflected beam 5.

### List of references

- 1: plasma chamber
- 2: detector, for scattered light
- 3: detector, for reflected beam
- 4: incident beam of light
- 5: reflected beam of light
- 6: scattered light
- 7: light source, laser
- 8: intensity of scattered light
- 8': intensity of reflected light
- 9: polymer film, flaking material
- 10: wall surface
- 11: area / spot on wall surface
- 12: exhaust tube
- 13: control unit
- 14: threshold value for flaking
- 15: light source window
- 16: detector window

## Claims

1. Arrangement for detecting sidewall flaking in a plasma chamber (1) of a plasma etch reactor, which is used for etching a semiconductor device, comprising
- a light source (7), which is arranged to emit a beam of light (4) towards an area (11) on a inner wall surface (10), which is positioned inside the plasma chamber (1) of said plasma etch reactor,
- at least one detector (2) for detecting and measuring the intensity (8) of light emitted by said light source and being scattered by said area (11) of said inner wall surface (10),
- a control unit (13) being connected to said light source (7) and to said detector (2).

2. Arrangement according to claim 1,
**characterized in that**
said light source (7) is a laser.

3. Arrangement according to anyone of claims 1 to 2,
**characterized by**
- said chamber (1) having a space being covered by a beam of light (5) being reflected by said inner wall surface (10),
- said at least one detector (2) being mounted outside said space.

4. Arrangement according to anyone of claims 1 to 3,
**characterized in that**
said light source (7) is moveably mounted to provide a multiple of said areas (11) to be covered by said beam of light (4).

5. Arrangement according to anyone of claims 1 to 4,
**characterized in that**
- said light source (7) is mounted outside said plasma chamber (1),
- said plasma chamber (1) comprises at least one light source window (15), which is transparent for said beam of light (4) to be emitted into said plasma chamber (1).

6. Arrangement according to anyone of claims 1 to 5,
**characterized in that**
said detector (2) is one of a group comprising:
a) a CCD-device,
b) a photo diode array.

7. Arrangement according to claim 6,
**characterized in that**
- said at least one detector (2) is mounted outside said plasma chamber (1),
- said plasma chamber (1) comprises at least one detector window (16), which is transparent for light emitting from said plasma chamber (1).

8. Arrangement according to claim 6,
**characterized in that**
said at least one detector (2) is mounted inside said plasma chamber (1).

9. Arrangement according to claim 7,
**characterized in that**
said detector window (16) and said light source window (15) denote the same window.

10. Arrangement according to anyone of claims 1 to 9,
**characterized by**
- said plasma reactor having an exhaust tube (12) leading to an evacuation pump,
- said detector (2) or said detector windoe (16) being located on an inner wall surface (10) on a sidewall of said exhaust tube (12).

11. Arrangement according to anyone of claims 1 to 10,
**characterized by**
- an array of said detectors (2) being arranged in a first line,
- a second array of detectors for measuring the intensity (8') of the reflected beam of light being arranged in a second line, which is placed:
a) along said first line,
b) on a line provided by the intersection of said reflected beam of light (5) with said wall surface (10).

12. Arrangement according to anyone of claims 1 to 11,
**characterized by**
an optical means for expanding said beam of light (4) emitted towards said area (11) on said inner wall surface (10) in a fanlike manner.

13. Arrangement according to anyone of claims 1 to 11,
**characterized by**
a rotatable mirror for changing the direction of said beam of light (4).

14. Method for detecting sidewall flaking in a plasma chamber (1) of a plasma etch reactor using the arrangement according to anyone of claims 1 to 13, comprising the steps of:
- emitting a beam of light (4) onto area (11) on the inner wall surface (10) inside said plasma chamber (1) using the light source (7),
- measuring the intensity (8) of the light (6) being scattered by flaking material (9) covering said wall surface (10) using said detector (2),
- comparing said intensity (8) with a threshold value (14),
- issuing a warning signal in response to said comparison.

15. Method according to claim 14,
**characterized in that**
- said wall surface (10) is an inner surface of a window mounted within said plasma chamber wall, said inner window surface being orientated towards the inner plasma chamber space,
- said beam of light (4) is directed onto said window surface through said window from outside said plasma chamber (1),
- said scattered light (6) being measured by a detector (2) is light being scattered from the backside of flaking material (9) deposited on said window surface through said window.

16. Method according to claim 14,
**characterized in that**
- a first detector (2) measures a first intensity (8) of said scattered light (6),
- a second detector (3) measures a second intensity (8') of said reflected beam of light (5),
- said first (8) and second (8') intensities are compared.

17. Method according to anyone of claims 14 to 16,
**characterized in that**
said measurement is performed while etching a semiconductor wafer.

18. Method according to claim 17,
**characterized by**
terminating etching in response to said signal.
